# EUROPÄISCHE PATENTSCHRIFT

(11) **EP 1 001 530 B1**
(45) Veröffentlichungstag und Bekanntmachung des Hinweises auf die Patenterteilung: **07.09.2011**
(21) Anmeldenummer: 99117840.1
(22) Anmeldetag: 10.09.1999
(51) Int. Cl.: H03H 1/00

(54) **Einrichtung zum Absorbieren des elektrischen Rauschens**
Device for the absorption of electrical noise
Dispositif d'absorption du bruit électrique

(30) Priorität: 16.09.1998 DE 19842323
(43) Veröffentlichungstag der Anmeldung: 17.05.2000
(73) Patentinhaber: Würth Elektronik eiSos GmbH & Co. KG, 74638 Waldenburg (DE)
(72) Erfinder: Konz, Oliver, 74532 Ilshofen (DE)
(74) Vertreter: Patentanwälte Ruff, Wilhelm, Beier, Dauster & Partner

(56) Entgegenhaltungen:
- EP-A- 0 452 992
- DE-A- 4 302 650
- DE-A- 19 536 155
- DE-U- 29 515 545
- US-A- 5 373 277
- US-A- 5 506 909

## Beschreibung

Es ist bekannt, dass man mit Hilfe von Elementen aus ferromagnetischem Material das elektrische Rauschen auf einer Leitung reduzieren oder die Ausbreitung verhindern kann (US 3 462 715).

Es ist bereits eine Einrichtung bekannt (EP 452 992), bei der zwei Halbelemente aus ferromagnetischem Material in einem geteilten Gehäuse untergebracht werden, dessen Böden elastische Vorspannmittel aufweisen, die die beiden magnetischen Elemente aufeinanderpressen. Bei dieser Beaufschlagung ist es erforderlich, daß die Elemente mit Hilfe von getrennten zusätzlichen Mitteln in dem Gehäuse gehalten werden.

Weiterhin ist eine Einrichtung zum Absorbieren des elektrischen Rauschens mit einem zwei Gehäuseteilschalen aufweisenden Gehäuse bekannt (US-A -5506909). Zur Festlegung der Ferrite dienen an den Innenkanten der Gehäusehalbschalen angeformte verformbare Lippen, die an den Längsseiten der Ferrite anliegen. Eine Festlegung des Gehäuses an dem Kabel selbst ist hier nicht vorgesehen.

Bei einem weiteren Rauschabsorber sind an den Stirnseiten einer Teilschale Leitungshalter ausgebildet, an der Innenseite ein Vorsprung zum Eingreifen in einer Kerbe des Ferrits angeformt ist (DE 4302650 A1).

Der Erfindung liegt die Aufgabe zugrunde, eine einfach aufgebaute Einrichtung zum Absorbieren des elektrischen Rauschens zu schaffen, die mit einfachen Mitteln auch an dem Kabel festgelegt werden kann.

Zur Lösung dieser Aufgabe schlägt die Erfindung eine Einrichtung mit den Merkmalen des Anspruchs 1 vor. Weiterbildungen der Erfindung sind Gegenstand der abhängigen Ansprüche, deren Wortlaut ebenso wie der Wortlaut der Zusammenfassung durch Bezugnahme zum Inhalt der Beschreibung gemacht wird.

Die Einrichtung wird so benutzt, dass die beiden Teile des Gehäuses mit den darin eingesetzten Elementen aus dem das Rauschen verhindernden Material um das Kabel herum angeordnet werden. Die Festlegeeinrichtung legt die Elemente in dem Gehäuse fest. In Weiterbildung der Erfindung ist vorgesehen, dass die Festlegeeinrichtung zum Festlegen des Gehäuses an dem Kabel ausgebildet ist. Damit lässt sich die Einrichtung in ihrem Aufbau und ihrer Herstellung weiter vereinfachen.

Erfindungsgemäß kann vorgesehen sein, dass die Festlegeeinrichtung vollständig innerhalb des Gehäuses angeordnet ist. Es gibt keinerlei vorstehende Teile. Insbesondere kann die Festlegeeinrichtung auch so angeordnet und ausgebildet sein, dass sie nicht in die Öffnung des Gehäuses hineinragt.

Erfindungsgemäß kann vorgesehen sein, dass die Festlegeeinrichtung an mindestens einer Stirnseite des Elements aus dem das Rauschen verhindernden oder reduzierenden Material angreift. Unter Stirnseite soll dabei diejenige Seite verstanden werden, in der die Nut mündet. Es ist erfindungsgemäß auch möglich, dass die Festlegeeinrichtung an mindestens einer Längsseite des Elements angreift, also an einer Seite, an der die Nut nicht ausmündet.

In weiterer Ausgestaltung der Erfindung ist vorgesehen, dass die Festlegeeinrichtung ein verformbares Kissen aufweist, das zwischen dem Gehäuse und dem Element angeordnet ist und die Festlegung durch eine Verklemmung bewirkt. Durch das Zusammenpressen des Kissens wird eine Kraft zwischen dem Gehäuse und dem Element bewirkt, die dieses festlegt. Dabei kann die Festlegekraft in Richtung der Trennfläche zwischen den beiden Elementen wirken.

Das verformbare Kissen ist als gummielastischer Stab beispielsweise mit einem runden, insbesondere kreisrunden Querschnitt ausgebildet. Dies ermöglicht auch ein gewisses Abrollen des Elements. In Weiterbildung der Erfindung ist vorgesehen, dass in Stirnansicht des Gehäuses der gummielastische Stab durch den Querschnitt der Durchgangsöffnung des geschlossenen Gehäuses verläuft. Dies bedeutet, dass die Festlegung des Gehäuses an dem Kabel durch das gummielastische Element erfolgt, das sich der Form des Kabels anpasst und dieses über einen Teil des Umfangs berührt. Eine solche Festlegung hat den großen Vorteil, dass keinerlei Eindringen eines Teiles in die Isolierung des Kabels auftritt, so dass das Kabel deutlich geschont wird.

Weitere Merkmale, Einzelheiten und Vorzüge der Erfindung ergeben sich aus der folgenden Beschreibung einer bevorzugten Ausführungsform der Erfindung sowie anhand der Zeichnung. Hierbei zeigen:
- Fig. 1: eine Aufsicht auf ein aufgeklapptes aus zwei Teilen bestehendes Gehäuse;
- Fig. 2: einen Längsschnitt durch das Gehäuse längs Linie II-II in Fig. 1;
- Fig. 3: eine Stirnansicht einer Gehäusehälfte.

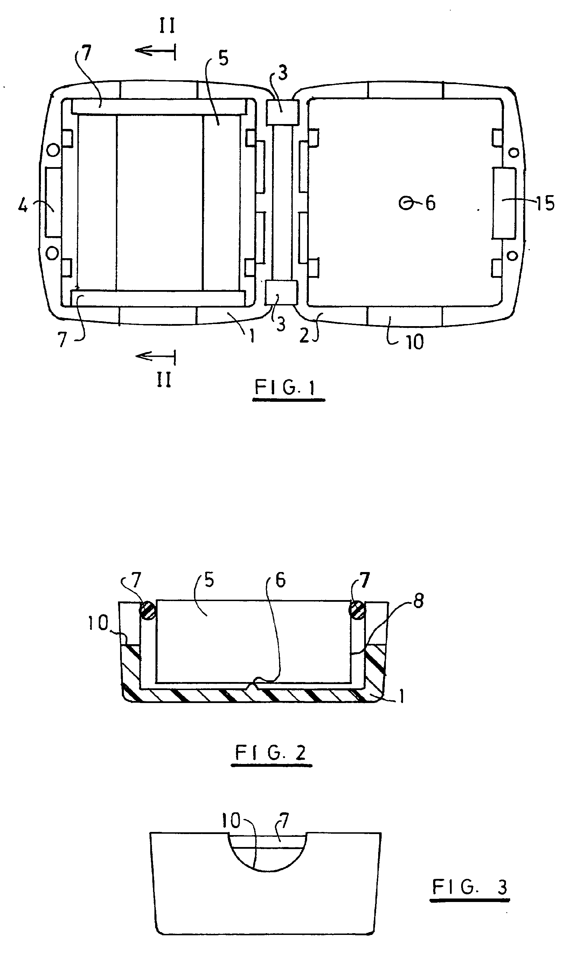

Fig. 1 zeigt eine Aufsicht auf ein aus zwei miteinander verbundenen Teilen bestehendes aufgeklapptes Gehäuse. Das Gehäuse enthält zwei Gehäusehalbteile 1, 2, die mit Hilfe eines angeformten Scharniers 3 miteinander verbunden sind. Zur Verriegelung des Gehäuses enthält die der Scharnierverbindung 3 abgewandte Längskante der einen Gehäusehälfte eine Vertiefung 4 und die gegenüberliegenden Längskante der anderen Gehäusehälfte einen Vorsprung 15, der in die Vertiefung hinein passt. An dem Vorsprung 15 können mit der Vertiefung 4 zusammenwirkende Rasteinrichtungen vorgesehen sein.

In die beiden Teile 1, 2 des Gehäuses werden Elemente 5 aus einem das Rauschen auf einer Leitung absorbierenden oder reduzierenden Material eingesetzt, wobei die Fig. 1 ein solches Element 5 nur in dem linken Teil 1 zeigt. Der Boden jedes Teils enthält mittig einen Vorsprung 6 in Form etwa einer Halbkugel, die zum Ausrichten der Elemente 5 bestimmt ist.

Zum Festlegen des Elements 5 ist eine Festlegeeinrichtung vorgesehen, die zwei aus gummiartigem Material bestehende verformbare Stäbe 7 enthält. Die beiden Stäbe 7 sind jeweils zwischen einer Stirnfläche 8 des Elements 5 und der Innenseite des Gehäuseteils 1, 2 eingesetzt. Das Einsetzen geschieht unter Vorspannung, so dass sich die Stäbe 7 verformen und dadurch eine Festlegekraft bewirken. Dies geht am besten aus Fig. 2 hervor, die einen Längsschnitt durch das Gehäuseteil 1 darstellt. Die Gummistäbe 7 liegen etwa im Bereich der Trennfläche 9 des Gehäuseteils 1. Aufgrund der Festklemmung zwischen den Elementen 5 und dem Gehäuse ist ihr Querschnitt zu einer Ellipse verformt.

Die Fig. 3 zeigt, dass der Stab 7 aus Gummi in einer Stirnansicht den Querschnitt der in dem geschlossenen Gehäuse gebildeten Durchgangsöffnung durchquert. Diese Durchgangsöffnung wird durch die beiden Halböffnungen 10 in den beiden Teilen 1, 2 des Gehäuses gebildet. Beim Zusammenklappen oder Zusammensetzen der beiden Teile 1, 2 des Gehäuses liegt das Kabel, auf dem das Rauschen absorbiert werden soll, zwischen den beiden Stäben aus Gummi, so dass diese Stäbe aus der geradlinigen Form ausgelenkt werden. Sie schmiegen sich über einen Teil des Umfangs des Kabels an. Das Gehäuse mit den Elementen 5 wird also an dem Kabel festgelegt, ohne dass die Befestigungseinrichtung mit einem Vorsprung oder dergleichen in die Isolierung des Kabels eindringt. Auch bei einem Verschieben der Einrichtung in Längsrichtung mit Kraftaufwand erfolgt keine Beschädigung des Kabels.

## Patentansprüche

1. Einrichtung zum Absorbieren bzw. Reduzieren des elektrischen Rauschens, mit
1.1 einem Gehäuse, das
1.1.1 zwei Gehäuseteilschalen (1, 2) zur Aufnahme je eines Elementes (5) aus ein Rauschen verhinderndem Material und
1.1.2 im zusammengesetzten Zustand in seinen beiden Stirnwänden je eine Durchgangsöffnung für ein elektrisches Kabel aufweist,
1.2 zwei Elementen (5) aus dem erwähnten Material, die
1.2.1 in den Gehäuseteilschalen (1, 2) angeordnet sind und
1.2.2 jeweils eine halbzylindrische Nut aufweisen, die
1.2.3 im zusammengesetzten Zustand des Gehäuses einen geschlossenen zylindrischen Durchgang für das elektrische Kabel bilden, sowie mit
1.3 einer Festlegeeinrichtung zum Festlegen der Elemente (5) aus dem erwähnten Material in der jeweiligen Teilschale (1),
**dadurch gekennzeichnet, dass**
1.4 die Festlegeeinrichtung auch zur Festlegung des Gehäuses an dem Kabel ausgebildet ist und
1.5 einen verformbaren zwischen den Elementen und dem Gehäuse verklemmbaren gummielastischen Stab (7) aufweist, der
1.6 in Stirnansicht durch den Querschnitt des Durchgangs der zusammengesetzten Elemente (5) verläuft.

2. Einrichtung nach Anspruch 1, bei der die Festlegeeinrichtung vollständig innerhalb des Gehäuses angeordnet ist.

3. Einrichtung nach einem der vorhergehenden Ansprüche, bei der die Festlegeeinrichtung an mindestens einer Stirnseite (8) des Elements (5) angreift .

4. Einrichtung nach einem der vorhergehenden Ansprüche, bei der die Festlegeeinrichtung an mindestens einer Längsseite des Elementes (5) angreift.

5. Einrichtung nach einem der vorhergehenden Ansprüche, bei der der gummielastische Stab (7) einen runden Querschnitt aufweist.

6. Einrichtung nach einem der vorhergehenden Ansprüche, bei der der Stab (7) in Stirnansicht gesehen durch die Durchgangsöffnung des geschlossenen Gehäuses verläuft.

## Claims

1. Device for the absorption or reduction of electrical noise, having
1.1 a housing which
1.1.1 has two housing shell elements (1, 2), each for holding one element (5) composed of a material which prevents noise, and
1.1.2 an aperture opening for an electrical cable in each of its two end walls in the assembled state,
1.2 two elements (5) composed of said material, which
1.2.1 are arranged in the housing shell elements (1, 2) and
1.2.2 each have a half-cylindrical groove which
1.2.3 form a closed cylindrical passage for the electrical cable when the housing is in the assembled state, and having
1.3 a fixing device for fixing the elements (5) composed of said material in the respective shell element (1),
**characterized in that**
1.4 the fixing device is also designed to fix the housing to the cable, and
1.5 has a deformable, elastomeric bar (7) which can be clamped between the elements and the housing and
1.6 runs, in an end view, through the cross section of the passage through the assembled elements (5).

2. Device according to Claim 1, therein the fixing device is arranged completely within the housing.

3. Device according to one of the preceding claims, wherein the fixing device acts on at least one end face (8) of the element (5).

4. Device according to one of the preceding claims, wherein the fixing device acts on at least one longitudinal face of the element (5).

5. Device according to one of the preceding claims, wherein the elastomeric bar (7) has a round cross section.

6. Device according to one of the preceding claims, therein, seen in an end view, the bar (7) runs through the aperture opening in the closed housing.

## Revendications

1. Dispositif pour absorber ou réduire le bruit électrique, comprenant :
1.1 un boîtier qui
1.1.1 présente deux coques partielles de boîtier (1, 2) pour accueillir chacune un élément (5) en un matériau qui empêche le bruit et,
1.1.2 dans l'état assemblé, une ouverture de passage dans chacune de ses deux parois frontales pour un câble électrique,
1.2 deux éléments (5) en le matériau mentionné, qui
1.2.1 sont disposés dans les coques partielles de boîtier (1, 2) et qui
1.2.2 présentent respectivement une rainure semi-cylindrique,
1.2.3 lesquels, dans l'état assemblé du boîtier, forment un passage cylindrique fermé pour le câble électrique,
et comprenant aussi
1.3 un dispositif de fixation pour fixer les éléments (5) en le matériau mentionné dans la coque partielle (1) correspondante,
**caractérisé en ce que**
1.4 le dispositif de fixation est également configuré pour fixer le boîtier au câble et
1.5 il présente une tige (7) souple en caoutchouc déformable et qui peut être coincée entre les éléments et le boîtier et qui ; vue de l'avant, s'étend à travers la section transversale du passage des éléments (5) assemblés.

2. Dispositif selon la revendication 1, dans lequel le dispositif de fixation est entièrement disposé à l'intérieur du boîtier.

3. Dispositif selon l'une des revendications précédentes, dans lequel le dispositif de fixation vient en prise au moins sur un côté frontal (8) de l'élément (5).

4. Dispositif selon l'une des revendications précédentes, dans lequel le dispositif de fixation vient en prise au moins sur un côté longitudinal de l'élément (5).

5. Dispositif selon l'une des revendications précédentes, dans lequel la tige (7) souple en caoutchouc présente une section transversale ronde.

6. Dispositif selon l'une des revendications précédentes, dans lequel la tige (7), vue de l'avant, s'étend à travers l'ouverture de passage du boîtier fermé.
